# EUROPEAN PATENT APPLICATION

(11) **EP 3 995 255 A1**
(43) Date of publication of application: **11.05.2022**
(21) Application number: 20834645.2
(22) Date of filing: 19.06.2020
(51) Int. Cl.: B24D 3/02, B24D 3/00, B24D 3/14, B24D 3/28, C09K 3/14, H01L 21/304

(54) **SYNTHETIC GRINDING STONE**

(30) Priority: 02.07.2019 JP 2019123773
(71) Applicant: TOKYO DIAMOND TOOLS MFG. CO., LTD., Meguro-ku Tokyo 152-0031 (JP)
(72) Inventor: TSUDA, Masaaki, Tokyo 152-0031 (JP)
(74) Representative: AWA Sweden AB
(86) International application number: PCT/JP2020/024053
(87) International publication number: WO 2021/002216

(57) **Abstract**

A synthetic grindstone (100) for chemo-mechanical grinding a wafer S, comprising: an abrasive (101) that contains cerium oxide having an average particle diameter of 10 µm or less as a main component and has a chemo-mechanical grinding action on the wafer S; a friction promoter (102) that contains a fiber material having a Mohs hardness lower than that of the wafer S and a high friction coefficient as a main component and promotes heat generation; and a binder (103) that contains a phenol resin as a main component and disperses and binds the abrasive (101) and the friction promotor (102).

## Description

### FIELD

The present invention relates generally to a synthetic grindstone for grinding a surface of an object to be ground such as a silicon wafer.

### BACKGROUND

In the field of semiconductor manufacturing, a surface of a silicon wafer serving as a substrate of a semiconductor element is generally processed in such a manner that a wafer obtained by slicing a silicon single crystal ingot is mirror-finished through several processes such as a lapping process, an etching process, and a polishing process. In the lapping process, dimensional accuracy such as parallelism and flatness and shape accuracy are obtained. Next, in the etching process, a work-affected layer formed in the lapping process is removed. In the polishing process, chemo-mechanical polishing (hereinafter, referred to as "CMP") is performed to form a wafer having a surface roughness of a mirror surface level while maintaining good shape accuracy. Further, a polishing process equivalent thereto is also used when removing damage of a grinding process called backgrind in a semiconductor back-end process.

In recent years, a method of surface processing by dry chemo-mechanical grinding (hereinafter, referred to as "CMG") has been used in place of the polishing process (e.g., refer to Patent Literature 1). In the CMG process, a synthetic grindstone in which an abrasive (abrasive grain) is fixed with a resin binder such as a hard resin is used. Then, the synthetic grindstone is pressed against a wafer while rotating the wafer and the synthetic grindstone (e.g., refer to Patent Literature 2). Convex portions on the wafer surface become brittle due to heating and oxidation of fine processing starting points caused by friction with the synthetic grindstone, and fall off. In this way, only the convex portions of the wafer are ground and planarized.

In addition, there has been proposed a synthetic grindstone that improves processing efficiency by improving a grinding rate in a CMG process (e.g., refer to Patent Literature 3).

### CITATION LIST

### PATENT LITERATURES

[Patent Literature 1] Japanese Patent No. 4573492
[Patent Literature 2] Japanese Patent Application KOKAI Publication No. 2004-87912
[Patent Literature 3] Japanese Patent Application KOKAI Publication No. 2016-82127

### SUMMARY

### TECHNICAL PROBLEM

The above-described synthetic grindstone has the following problems. That is, as described above, in the CMG process, since material removal using a chemical reaction between solids is a processing principle, a processing speed does not increase unless a reaction heat increases sufficiently. In addition, there has also been a problem that the abrasive released from the synthetic grindstone is discharged by a centrifugal force caused by rotation of the synthetic grindstone or the wafer and does not participate in the grinding action, resulting in a decrease in processing speed.

The present invention has been made to solve the above-described problems, and an object of the present invention is to provide a synthetic grindstone that realizes a high grinding efficiency in grinding.

### SOLUTION TO PROBLEM

A synthetic grindstone according to the present embodiment includes an abrasive having a chemo-mechanical grinding action on a material to be ground, a friction promotor, and a binder that binds the abrasive and the friction accelerator.

The synthetic grindstone according to the present embodiment includes an abrasive having a chemo-mechanical grinding action on a material to be ground and a binder that binds the abrasive, and in the binder, a thickener having a thickening action is impregnated or the thickener is dissolved in a low-melting-point wax and impregnated.

### ADVANTAGEOUS EFFECTS OF INVENTION

It is possible to realize a high grinding efficiency by promoting heat generation by friction in grinding to increase a temperature in a short time.

### BRIEF DESCRIPTION OF THE DRAWINGS

FIG. 1 is a perspective view showing a CMG device incorporating a synthetic grindstone according to a first embodiment of the present invention.
FIG. 2 is a perspective view showing the synthetic grindstone.
FIG. 3 is an explanatory view showing a structure of the synthetic grindstone.
FIG. 4 is an explanatory view showing an action principle of the synthetic grindstone.
FIG. 5 is an explanatory view showing a structure and a manufacturing method of a synthetic grindstone according to a second embodiment of the present invention.
FIG. 6 is an explanatory view showing an action principle of the synthetic grindstone according to the second embodiment of the present invention.
FIG. 7 is an explanatory view showing a structure and a manufacturing method of a synthetic grindstone according to a third embodiment of the present invention.
FIG. 8 is an explanatory view showing an action principle of the synthetic grindstone according to the third embodiment of the present invention.

### DETAILED DESCRIPTION

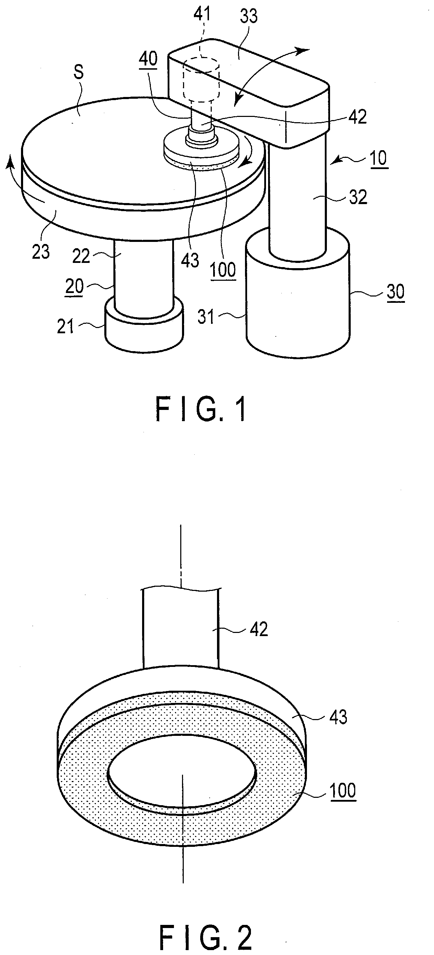

FIGS. 1 to 4 are views showing a first embodiment of the present invention. In these figures, S denotes a silicon wafer (object to be ground) to be ground. As shown in FIG. 1, a CMG device 10 includes a rotary table mechanism 20 that supports the wafer S, and a grindstone support mechanism 30 that supports a synthetic grindstone 100 to be described later. The CMG device 10 forms a part of a wafer processing apparatus. The wafer S is loaded into and unloaded from the CMG device 10 by a transfer robot, etc.

The rotary table mechanism 20 includes a table motor 21 arranged on a floor surface, a table shaft 22 arranged so as to protrude upward from the table motor 21, and a table 23 attached to an upper end of the table shaft 22. The table 23 has a mechanism for detachably holding the wafer S to be ground. The holding mechanism includes, for example, a vacuum suction mechanism.

The grindstone support mechanism 30 includes a base 31 arranged on the floor surface and accommodating a motor therein, a vertical swing shaft 32 supported by the base 31 and swung in a direction indicated by an arrow in FIG. 1 by the motor in the base 31, an arm 33 provided at an upper end of the swing shaft 32 and extending in a horizontal direction, and a grindstone drive mechanism 40 provided at a distal end side of the arm 33.

The grindstone drive mechanism 40 includes a rotary motor part 41. The rotary motor part 41 includes a rotary shaft 42 protruding downward. A disk-shaped wheel holding member 43 is attached to a distal end portion of the rotary shaft 42. As shown in FIG. 2, a disk-shaped synthetic grindstone 100 is detachably attached to the wheel holding member 43. The synthetic grindstone 100 is mounted by screwing a bolt into a screw hole provided in the synthetic grindstone 100 from the wheel holding member 43 side.

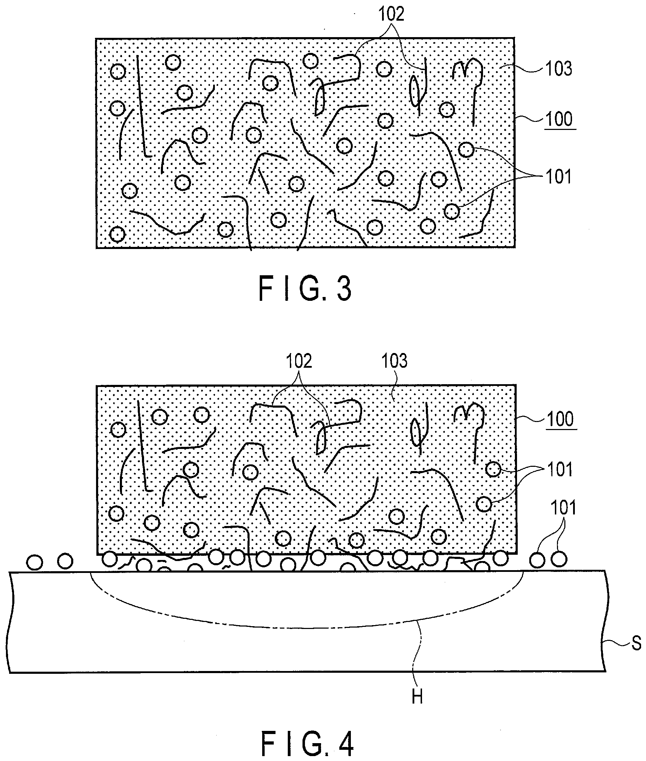

As shown in FIG. 3, the synthetic grindstone 100 has an abrasive 101 having a chemo-mechanical grinding action on the wafer S, and is formed by dispersing a friction promoter 102 in the abrasive 101 and binding them with a binder 103 to form pores. The abrasive 101 is appropriately selected depending on the material of the material to be ground, and when the wafer S is made of a silicon material, it is preferable that cerium oxide having an average particle diameter of 10 µm or less be used as a main component. In addition to cerium oxide, silicon oxide, iron oxide, titanium oxide, and chromium oxide can also be used, and a mixture thereof may be used.

The friction promoter 102 contains a fiber material having a Mohs hardness lower than that of the wafer S and a high friction coefficient as a main component. As the fiber material, any one of whiskers (crystals grown in a whisker shape from a crystal surface to the outside) and fibers, or a mixture thereof, can be applied. As the whiskers, an oxide-based whisker and a carbide-based whisker having a high mechanical strength are preferable. As the fibers, cellulose fibers and carbon fibers are preferable. The binder 103 contains an organic compound-based resin such as a phenol resin, a urethane resin, and an epoxy resin, or a low-melting-point vitreous binder as a main component.

The composition of the synthetic grindstone 100 is, for example, 40 to 55 vol% of the abrasive 101, 1 to 5 vol% of the friction promoter 102, and 9 to 30 vol% of the binder 103. The porosity of the synthetic grindstone 100 is 10 to 50 vol%. The pores are filled with the friction promoter 102.

The synthetic grindstone 100 formed as described above is attached to the CMG device 10 and grinds the wafer S in the following manner. That is, the synthetic grindstone 100 is attached to the wheel holding member 43. Next, the wafer S is mounted on the table 23 by the transfer robot.

Then, the table motor 21 is driven to rotate the table 23 in a direction indicated by an arrow in FIG. 1. Further, the rotary motor part 41 is driven to rotate the wheel holding member 43 and the synthetic grindstone 100 in a direction indicated by an arrow in FIG. 1. The synthetic grindstone 100 is rotated at a peripheral speed of, for example, 600 m/min and is pressed toward the wafer S side at a processing pressure of 300 g/cm². Then, the swing shaft 32 is swung in a direction indicated by an arrow in FIG. 1. By these parts interlocking together, the synthetic grindstone 100 and the wafer S slide against each other.

A relationship between the synthetic grindstone 100 and the wafer S at this time is shown in FIG. 4. When the processing is started, the synthetic grindstone 100 and the wafer S slide against each other, and an external force acts on the binder 103. A continuous action of this external force loosens the binder 103, and the abrasive 101 and the soft friction promoter 102 fall off onto the wafer S. The released abrasive 101 is entangled with the fibrous friction promoter 102 and slides in a space between the synthetic grindstone 100 and the wafer S. The abrasive 101 has a chemical polishing action and stays on a surface of the wafer S for a long time, which leads to an improvement in frequency of the chemical polishing action.

On the other hand, the friction promoter 102 repeats microscopic adhesion and peeling by rubbing against the surface of the wafer S and the abrasive 101. This action acts as a braking action, whereby frictional heat is generated. Since frictional heat is also generated between the abrasive 101 and the binder 103, and the wafer S, the frictional heat is added to the aforementioned frictional heat. H in FIG. 4 shows a state in which frictional heat generated in the space between the synthetic grindstone 100 and the wafer S spreads from the surface of the wafer S to the inside of the wafer S.

A processing amount L in the CMG process is derived from Preston's formula. That is, it is expressed as L = k · P · V · t (k: Preston coefficient, P: grindstone surface pressure, V: grindstone relative speed, t: processing time). One factor of the proportionality constant k that promotes a polishing efficiency (V/t) is thermal influence.

A thermo-chemical reaction formula is generally expressed as k (rate constant) = Aexp (-E/RT) according to the Arrhenius equation (A: reaction coefficient, E: activation energy, R: gas constant, T: absolute temperature), and has a positive correlation with the absolute temperature T. Therefore, when heat is generated in a processing atmosphere by increasing the amount of heat generation, the heat becomes a driving energy for chemical reaction, the chemical reaction is promoted, and the processing amount increases.

On the other hand, since a friction coefficient µ and a generated heat amount Q are expressed by a general formula ΔQ = µ · ΔW · v/J (ΔW: added work amount, v: slip speed, J: conversion constant for converting work amount into heat amount), the absolute temperature T is expressed as an integral value of Q with an increase in friction coefficient. Thus, the greater the friction coefficient, in particular, the greater a dynamic friction coefficient, the greater the temperature rise.

In this way, the friction promoter 102 is used to promote the chemical reaction due to the temperature rise of the surface of the wafer S, and the grinding efficiency is increased, whereby a processing time of the surface grinding of the wafer S by the CMG device 10 and the synthetic grindstone 100 can be shortened.

According to the synthetic grindstone 100 of the present embodiment, the grinding efficiency can be increased and the processing time can be shortened by combining the temperature increase effect of the friction promoter 102 and the retention effect of the abrasive 101.

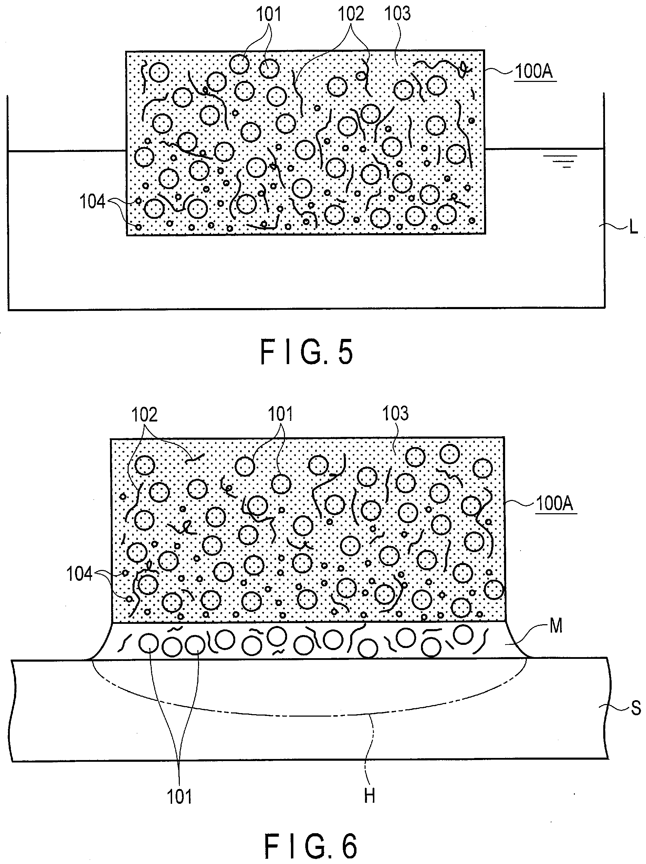

FIGS. 5 and 6 are views showing a second embodiment of the present invention. In these figures, the same functional portions as those in FIGS. 1 to 4 are denoted by the same reference numerals, and detailed descriptions thereof will be omitted. A synthetic grindstone 100A according to the second embodiment of the present invention is attached to the CMG device 10 in the same manner as the above-described synthetic grindstone 100.

In the synthetic grindstone 100A, a thickener 104 is added to the synthetic grindstone 100. A main component of the thickener 104 is, for example, glycerin. In addition to glycerin, glycol may be used, or a mixture thereof may be used. In addition, as a method of adding the thickener 104, direct mixing may be performed, or as shown in FIG. 5, impregnation with glycerin, etc. dissolved in a low-melting-point wax may be performed.

The synthetic grindstone 100A formed as described above is attached to the CMG device 10 and grinds the wafer S in the same manner as the synthetic grindstone 100 described above.

A relationship between the synthetic grindstone 100A and the wafer S at this time is shown in FIG. 6. When the processing is started, the synthetic grindstone 100A and the wafer S slide against each other, and an external force acts on the binder 103. A continuous action of this external force loosens the binder 103, and the abrasive 101 and the soft friction promoter 102 fall off onto the wafer S. The released abrasive 101 is entangled with the fibrous friction promoter 102 and is slid in the space between the synthetic grindstone 100A and the wafer S. The abrasive 101 has a chemical polishing action and stays on the surface of the wafer S for a long time, which leads to an improvement in frequency of the chemical polishing action.

Furthermore, frictional heat is generated by the sliding between the synthetic grindstone 100A and the wafer S and the sliding of the friction promoter 102. As a result, components of the thickener 104 impregnated inside the synthetic grindstone 100A together with the low-melting-point wax, i.e., glycerin, begin to elute. Since the low-melting-point wax has a low molecular weight, a lubricating action between the synthetic grindstone 100A and the wafer S is limited. The thickener 104 eluted in the same manner as the low-melting-point wax becomes a high-viscosity liquid M between the synthetic grindstone 100A and the wafer S.

As a result, the liquid M becomes a liquid having a high shearing stress in a very narrow space between the synthetic grindstone 100A and the wafer S, thereby generating frictional heat. The generated frictional heat tends to stay in the liquid M to promote a chemical reaction due to the temperature rise, thereby increasing the grinding efficiency. Therefore, it is possible to shorten the processing time of the surface grinding of the wafer S by the CMG device 10 and the synthetic grindstone 100A. H in FIG. 6 shows a state in which frictional heat generated in the space between the synthetic grindstone 100A and the wafer S spreads from the surface of the wafer S to the inside of the wafer S. Since the abrasive 101 is trapped inside the high-viscosity liquid N, a discharge action of the abrasive 101 is suppressed, and a retention time of the abrasive 101 is increased, so that there is an effect whereby the frequency of the chemical polishing action is improved.

According to the synthetic grindstone 100A of the present embodiment, the grinding efficiency can be increased by combining the temperature increase effect of the friction promoter 102 and the thickener 104 and the retention effect of the abrasive 101, and the processing time can be shortened.

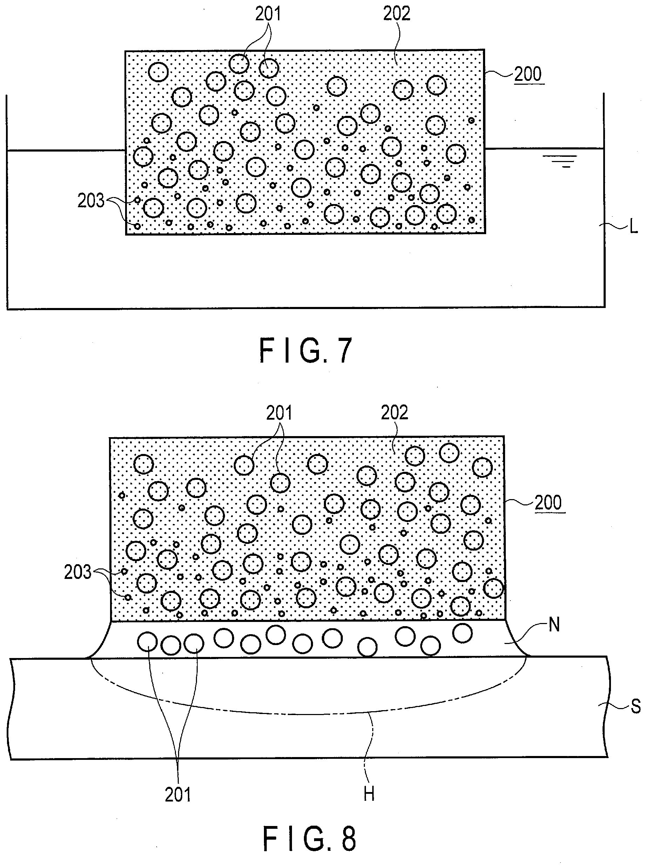

FIGS. 7 and 8 are views showing a third embodiment of the present invention. In these figures, the same functional portions as those in FIGS. 1 to 6 are denoted by the same reference numerals, and detailed descriptions thereof will be omitted. A synthetic grindstone 200 according to the second embodiment of the present invention is attached to the CMG device 10 in the same manner as the synthetic grindstone 100 described above.

The synthetic grindstone 200 is formed of an abrasive 201 having a chemo-mechanical grinding action on the wafer S, and a binder 202 for dispersing and binding the abrasive 201. In addition, a thickener 203 having a thickening effect is dissolved in a low-melting-point wax and is impregnated in the binder 202 as shown in FIG. 7.

The abrasive 201 is appropriately selected depending on the material of a material to be ground, and when the wafer S is made of a silicon material, it is preferable that cerium oxide having an average particle diameter of 10 µm or less be used as a main component. In addition to cerium oxide, silicon oxide, iron oxide, titanium oxide, and chromium oxide can also be used, and a mixture thereof may be used.

The binder 202 contains an organic substance such as a phenol resin or a low-melting-point vitreous binder as a main component. A main component of the thickener 203 is, for example, glycerin. In addition to glycerin, glycol may be used, or a mixture thereof may be used. In addition, as a method of adding the thickener 203, direct mixing may be performed, or as shown in FIG. 7, impregnation with glycerin, etc. dissolved in a low-melting-point wax may be performed.

The synthetic grindstone 200 formed as described above is attached to the CMG device 10 and grinds the wafer S in the following manner. That is, the synthetic grindstone 200 is attached to the wheel holding member 43. Next, the wafer S is mounted on the table 23 by the transfer robot.

Then, the table motor 21 is driven to rotate the table 23 in the direction indicated by the arrow in FIG. 1. Further, the rotary motor part 41 is driven to rotate the wheel holding member 43 and the synthetic grindstone 100 in the direction indicated by the arrow in FIG. 1. The synthetic grindstone 200 is rotated at a peripheral speed of, for example, 600 m/min and is pressed toward the wafer S side at a processing pressure of 300 g/cm². Furthermore, the swing shaft 32 is swung in the direction indicated by the arrow in FIG. 1. By these parts interlocking together, the synthetic grindstone 200 and the wafer S slide against each other.

A relationship between the synthetic grindstone 200 and the wafer S at this time is shown in FIG. 8. When the processing is started, the synthetic grindstone 200 and the wafer S slide against each other, and an external force acts on the binder 202. A continuous action of this external force loosens the binder 202, and the abrasive 201 falls off onto the wafer S. The abrasive 201 has a chemical polishing action, and grinding of the surface of the wafer S is started.

On the other hand, frictional heat is generated by the sliding between the synthetic grindstone 200 and the wafer S. As a result, components of the thickener 203 impregnated inside the synthetic grindstone 200 together with the low-melting-point wax, i.e., glycerin, begin to elute. Since the low-melting-point wax has a small molecular weight, a lubricating action between the synthetic grindstone 200 and the wafer S is limited. The thickener 203 eluted in the same manner as the low-melting-point wax becomes a high-viscosity liquid N between the synthetic grindstone 200 and the wafer S.

As a result, the liquid N becomes a liquid having a high shearing stress in a very narrow space between the synthetic grindstone 200 and the wafer S, thereby generating frictional heat. The generated frictional heat tends to stay in the liquid N to promote a chemical reaction due to the temperature rise, thereby increasing the grinding efficiency. Therefore, it is possible to shorten the processing time of the surface grinding of the wafer S by the CMG device 10 and the synthetic grindstone 200. H in FIG. 8 shows a state in which the frictional heat generated in the space between the synthetic grindstone 200 and the wafer S spreads from the surface of the wafer S to the inside of the wafer S. Since the abrasive 201 is trapped inside the high-viscosity liquid N, a discharge action of the abrasive 201 is suppressed, and a retention time of the abrasive 201 is increased, so that there is an effect whereby a frequency of the chemical polishing action is increased.

In this way, the temperature rise of the surface of the wafer S can be promoted by using the thickener 203, and the abrasive 201 can be stopped on the action surface. Therefore, by increasing the grinding efficiency, it is possible to shorten the processing time of the surface grinding of the wafer S by the CMG device 10 and the synthetic grindstone 200.

According to the synthetic grindstone 200 of the present embodiment, the grinding efficiency can be increased by combining the temperature increase effect of the thickener 203 and the retention effect of the abrasive 201, and the processing time can be shortened.

It should be noted that the present invention is not limited to the above-described embodiments, and various modifications can be made without departing from the scope of the present invention at the stage of implementation. In addition, the embodiments may be appropriately combined and implemented, and in this case, combined effects are obtained. Furthermore, various inventions are included in the above-described embodiments, and various inventions can be extracted by a combination selected from a plurality of disclosed constituent elements. For example, even if some constituent elements are deleted from all the constituent elements shown in the embodiments, when the problem can be solved and an effect can be obtained, a configuration from which the constituent elements are deleted can be extracted as an invention.

### REFERENCE SIGNS LIST

10 ... CMG device, 20 ... rotary table mechanism, 21 ... table motor, 22 ... table shaft, 23 ... table, 30 ... grindstone support mechanism, 31 ... base, 32 ... swing shaft, 33 ... arm, 40 ... grindstone drive mechanism, 41 ... rotary motor part, 42 ... rotary shaft, 43 ... wheel holding member, 100, 100A ... synthetic grindstone, 101 ... abrasive, 102 ... friction promotor, 103 ... binder, 104 ... thickener, 200 ... synthetic grindstone, 201 ... abrasive, 202 ... binder, 203 ... thickener, S ... wafer

## Claims

1. A synthetic grindstone for chemo-mechanical grinding a material to be ground, comprising:
an abrasive having a chemo-mechanical grinding action on the material to be ground;
a friction promoter; and
a binder that binds the abrasive and the friction promotor.

2. The synthetic grindstone according to claim 1,
wherein the abrasive contains any one of cerium oxide, silicon oxide, iron oxide, titanium oxide, and chromium oxide, or a mixture thereof, as a main component, and has an average particle diameter of 10 µm or less.

3. The synthetic grindstone according to claim 1,
wherein the friction promoter contains a fiber material having a lower Mohs hardness than the material to be ground and a high friction coefficient as a main component.

4. The synthetic grindstone according to claim 3,
wherein the friction promoter contains any one of a whisker and a fiber, or a mixture thereof, as a main component.

5. The synthetic grindstone according to claim 1,
wherein the binder contains an organic compound-based resin or a low-melting-point vitreous binder as a main component.

6. The synthetic grindstone according to claim 1,
wherein in the binder, a thickener having a thickening effect is impregnated, or the thickener is dissolved in a low-melting-point wax and impregnated.

7. The synthetic grindstone according to claim 6,
wherein the thickener contains at least one of glycerin and glycol as a main component.

8. A synthetic grindstone for chemo-mechanical grinding a material to be ground, comprising:
an abrasive having a chemo-mechanical grinding action on the material to be ground; and
a binder that binds the abrasive,
wherein in the binder, a thickener having a thickening action is impregnated, or the thickener is dissolved in a low-melting-point wax and impregnated.

9. The synthetic grindstone according to claim 8,
wherein the thickener contains at least one of glycerin and glycol as a main component.
